# EUROPEAN PATENT APPLICATION

(11) **EP 0 967 637 A1**
(43) Date of publication of application: **29.12.1999**
(21) Application number: 99304772.9
(22) Date of filing: 18.06.1999
(51) Int. Cl.: H01L 21/762, H01L 21/28, H01L 29/423

(54) **Semiconductor device and manufacturing method**

(30) Priority: 24.06.1998 US 103896
(71) Applicant: SIEMENS AKTIENGESELLSCHAFT, 80333 München (DE); International Business Machines Corporation, Armonk, NY 10504 (US)
(72) Inventor: Parries, Paul, Wappingers Falls, NY 12590 (US); Liebman, Lars, Poughquag, NY 12570 (US); Thanh, Liem Do, Glen Allen, VA 23060 (US)
(74) Representative: Litchfield, Laura Marie

(57) **Abstract**

A semiconductor structure having a semiconductor substrate with a trench disposed in the substrate. A dielectric material is disposed in the trench. A barrier liner is disposed over sidewall portions of the trench. A field effect transistor is provided having: a source region; a drain region; and a gate channel region having different lengths disposed between the source and drain regions and with a width extending between opposing sidewall portions of the trench. A gate electrode is disposed over the gate channel region. The gate electrode has a length extending over opposing sidewall portions of the trench and a length over the opposing sidewall portions greater than a width over a region intermediate the opposing sidewall portions. The substrate is silicon, the barrier liner is silicon nitride or silicon oxynitride, and the dielectric material is TEOS. The trench is filled with the dielectric material with the dielectric material being deposited over the barrier liner. The dielectric material is annealed to densify such dielectric material.

## Description

This invention relates generally to semiconductor devices and manufacturing methods and more particularly to semiconductor devices having shallow trench isolation.

As is known in the art, active devices formed in semiconductor integrated circuits are electrically isolated by a dielectric. One technique to isolate devices formed in a silicon substrate is to form silicon dioxide regions between the devices. One technique is sometimes referred to as a local oxidation (LOCOS) process wherein exposed areas of the silicon are oxidized to form field oxide region between the devices. In another technique, a so-called shallow trench isolation (STI) technique, shallow trenches are formed in the exposed areas of the silicon and are then filled with a dielectric, typically TEOS. Prior to filling the trenches, a thin layer of silicon dioxide is thermally grown over the surface including sidewalls of the trenches. Next, a thin layer is silicon nitride is chemically vapor deposited over the silicon dioxide. A layer of TEOS is then deposited over the silicon nitride, portions of the TEOS filling the trench. The structure then typically undergoes a wet anneal during densification of the TEOS. The silicon nitride layer is used to prevent oxygen produced during the wet anneal from entering the silicon. That is, the silicon nitride prevents oxidation of the silicon trench sidewalls; otherwise, such oxidation would tend to create unwanted stresses and crystal dislocations in the silicon. The upper portions of the TEOS are removed to expose the portions of the surface of the silicon adjacent to STI region. The surface of the silicon is oxidized to for a gate oxide. Doped polycrystalline silicon is then formed over the gate oxide and photolithographically patterned into gate electrodes for MOSFET devices being formed.

In accordance with the present invention, a semiconductor structure is provided having a semiconductor substrate with a trench disposed in the substrate. A dielectric material is disposed in the trench. A barrier liner is disposed over sidewall portions of the trench. A field effect transistor is provided having: a source region; a drain region; and a gate channel region having different lengths disposed between the source and drain regions and with a width extending between opposing sidewall portions of the trench. A gate electrode is disposed over the gate channel region. The gate electrode has a width extending over opposing sidewall portions of the trench and different lengths over the opposing sidewall portions, a length over the sidewall portions of the trench being greater than a length over a region between the opposing sidewall portions. During subsequent process steps, (i.e., oxidation or densification in an oxidizing ambient), oxidizing species can penetrate the substrate through the STI sidewalls. This may tend to create unwanted stresses and crystal dislocations in the silicon substrate. A barrier liner of silicon nitride or oxynitride can block this penetration This barrier liner, however, while preventing these stresses, entraps electrons generated during the anneal process. That is, the dielectric material is annealed in an oxidizing environment to densify such deposited dielectric material while the barrier liner inhibits oxidation of the sidewall portions of the trenches. However, during the operation of the device, hot carriers (i.e., electrons or holes) can be injected into the STI region where they may become entrapped in the barrier liner. These entrapped electrons cause parasitic conduction paths along the STI sidewalls. That is, the entrapped electrons cause a parasitic conduction path on the sidewalls of the trenches. The sidewall portions of the trench pass along portions of the gate channel. Thus, the electrons entrapped along these portions of the gate channel adversely effect the characteristics of the MOSFET being formed. Merely increasing the length of the gate channel adversely effects performance of the MOSFET. Here, however, the gate channel length is increased only over the sidewalls of the trench and not over the region along the entire width of the gate channel to thereby reduced the effect of any electrons entrapped in the barrier liner without any significant adverse effect on MOSFET device performance.

In accordance with another feature of the invention, the substrate is silicon, and the barrier liner is silicon nitride or silicon oxynitride.

In accordance with another feature of the invention, a method is provided for forming a semiconductor structure. The method includes providing a semiconductor substrate. A trench is formed in the substrate. A barrier liner is formed over sidewall portions of the trench. The trench is filled with a dielectric material with the dielectric material being deposited over the barrier liner. The dielectric material is annealed to densify such dielectric material. A field effect transistor is formed with a gate electrode between a source and drain region, such gate electrode being configured with a length between the source and drain regions and with a width extending between opposing sidewall portions of the trench. The lengths of the gate electrode are configured with a length over the opposing sidewall portions greater than a length over a region intermediate the opposing sidewall portions.

For a better understanding of the present invention, and to show how it may be brought into effect, reference will now be made, by way of example, to the accompanying drawings, in which:
FIGS. 1A-1F are diagrammatical cross sectional sketches of a MOSFET at various stages in the fabrication thereof in accordance with the invention;
FIG. 2 is a plan view sketch of one of the MOSFET shown in FIG. 1F, the cross sectional view of such MOSFET in FIG. 1F being taken along line 1F-1F in FIG. 2;
FIG. 3 is a cross sectional sketch of the MOSFET shown in FIG. 2, such cross section being taken along line 3-3 in FIG. 2;
FIG. 4 is a cross sectional sketch of the MOSFET shown in FIG. 2, such cross section being taken along line 4-4 in FIG. 2; and
FIG. 5 is an isometric sketch, partially in cross section of a portion of the MOSFET of FIG. 2.

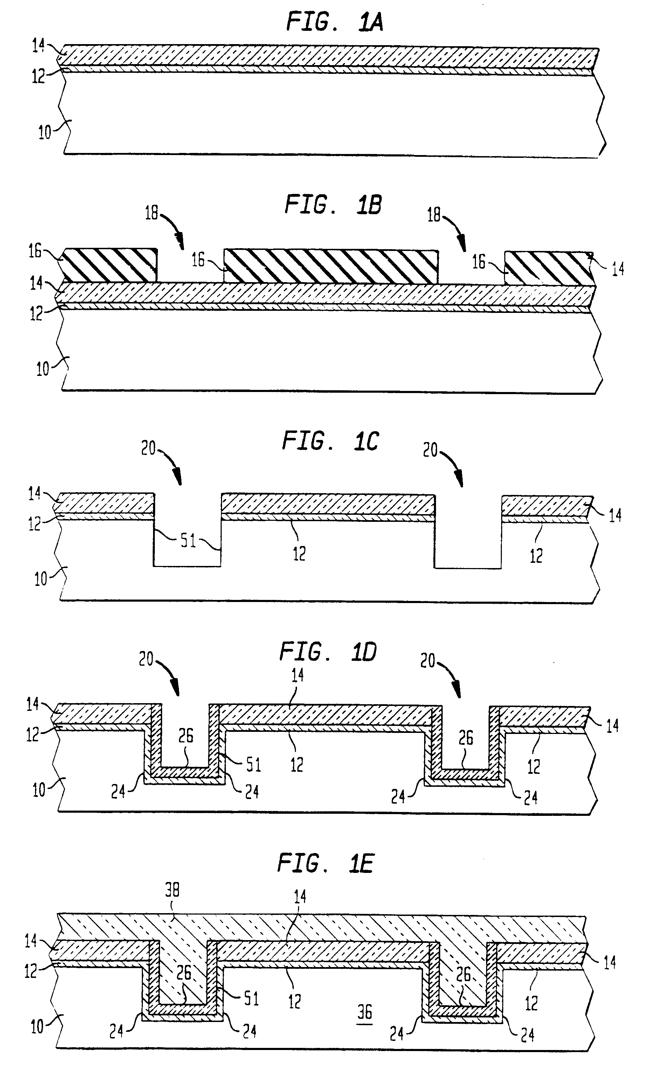

Referring now to FIG. 1A, a semiconductor body or substrate 10, here p-type conductivity silicon, is shown. A layer 12 of silicon dioxide is thermally grown over the upper surface of the substrate 10, here to a thickness in the range of 8 nanometers (nm). Next, a layer 14 of silicon nitride is deposited, here by Low Pressure Chemical Vapor Deposition (LPCVD) to a thickness of here in the range of about 200 nm on the silicon dioxide layer 14, as shown.

Referring now to FIG. 1B, a photoresist layer 16 of photoresist is deposited on the layer 14 of silicon nitride and photolithographically patterned, as shown, to have windows 18 formed therein over the regions of the substrate 10 where trenches for the STI are to be formed. Thus, the photoresist layer 16 is patterned to provide an etch mask, as shown in FIG. 1B. The structure is then exposed to an etch, here Reactive Ion Etch (RIE), to first remove the portions of the silicon nitride layer 14 exposed by the windows 18. Next, the exposed, underlying portions of the silicon dioxide layer 12 are removed by here RIE thereby exposing underlying portions of the surface of the silicon substrate 10. Next, the exposed portions of the silicon are etched, here using a Reactive Ion Etch (RIE), to form trenches 20 in the silicon substrate 10 surface as shown in FIG. 1C. The trench 20 has sidewall portions 51, as shown. The photoresist layer 16 is then stripped.

Referring now to FIG. 1D, a thin layer 24, here 13 nanometers (nm) thick, of silicon dioxide is thermally grown over the sidewall portions 51 (FIG. 1C) of the trenches 20. Next, a barrier material, here a liner, or layer 26 of silicon nitride is deposited over the structure. Here, the silicon nitride layer 26 is deposited by LPCVD to a thickness in the range of greater than 5 nm.

Next, referring also to FIG. 1E, a silicon dioxide dielectric material 38, here TEOS is deposited over the surface of the structure, portions of such TEOS being deposited in the trenches 20, as shown in FIG. 1E, portion of the material 38, not shown, extending over the silicon nitride layer 14. The structure undergoes a wet anneal and oxidation during densification of the TEOS material 38. The silicon nitride layer 26 is used to prevent oxygen produced during the wet anneal from entering the portions of the silicon substrate 10 where the MOSFET device is to be formed, i.e., the active region 36. That is, the silicon nitride layer 26 prevents oxidizing species from penetrating the silicon trench sidewalls 51; otherwise, such penetration would tend to create unwanted stresses and crystal dislocations in the silicon substrate 10. That is, the dielectric material 38 is annealed in an oxidizing environment to densify such deposited dielectric material 38 while the barrier silicon nitride layer 26 inhibits oxidation of the sidewall portions 51 of the trenches 20. However, during device operation the silicon nitride liner may entrap charge (i.e., holes or electrons). These entrapped charge cause parasitic conduction paths on the STI sidewalls 51. That is, the entrapped charge induces a parasitic conduction path on the sidewalls 51 of the trenches 20 thereby adversely effecting the characteristics of the MOSFET being formed. As will be described in detail hereinafter, here the gate channel length is increased only over the sidewall portions 51 of the trench 20 and not over the region along the width of the gate channel to thereby reduced the effect of any electrons entrapped in the silicon nitride liner 26 without any significant adverse effect on MOSFET device performance.

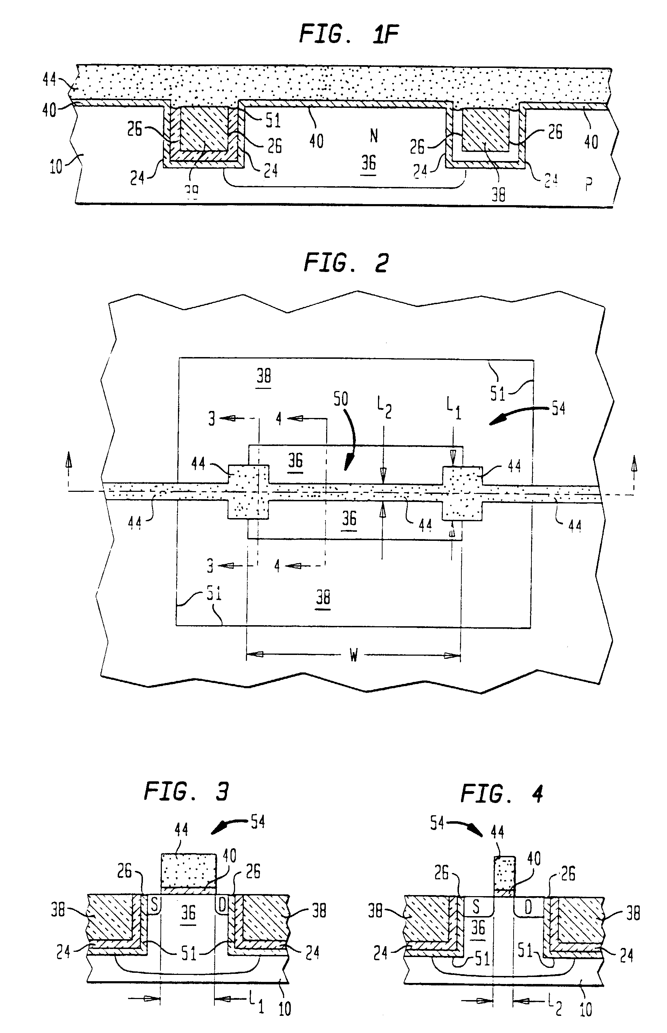

The upper portions, not shown, of the TEOS material 38 are removed here by chemical mechanical polishing (CMP). Next, the silicon nitride layer 14 and the silicon dioxide layer 12 are removed, here by wet etching, thereby exposing the surface portions of the silicon substrate 10. Next, referring to FIG. 1F, a layer 40 of silicon dioxide is thermally grown into the exposed surface portions of the silicon substrate 10, as shown. Next, a layer 44 of n⁺type conductivity doped polycrystalline silicon is deposited over the silicon dioxide layer 44, as shown. Next, an electrically conductive layer, not shown, here tungsten silicide (WSiₓ), is deposited over the polycrystalline silicon layer 44. The silicon dioxide layer 40, doped polycrystalline silicon layer 44, and electrically conductive layer, not shown, are patterned into a gate electrode 50 for the MOSFET 54, as shown in FIGS. 2, 3, 4 and 5. (That is, here the doped polycrystalline silicon and tungsten silicide are collectively referred to as gate electrode 50).

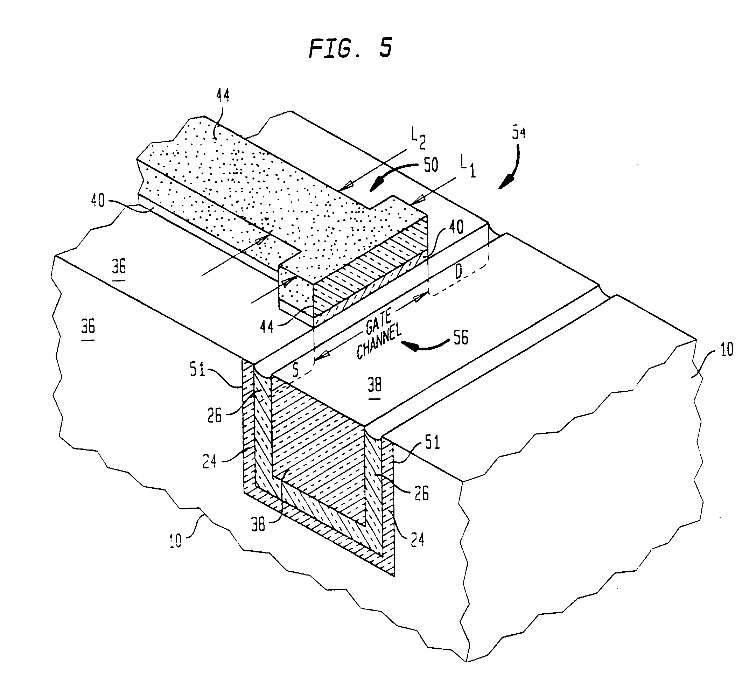

It is noted that the MOSFET 54 has a source region (S) disposed in the active region 36 of the substrate 10, a drain region (D) disposed in the active region 36 of the substrate 10, and a gate channel region 56 (FIG. 5) having different lengths (L₁, L₂) disposed between the source and drain regions (S, D) in the active region 36 of the substrate 10 and a width (W) extending between opposing sidewall portions 51 of the trench 38. The gate electrode 50 is disposed over, and in registration with (i.e., in alignment with), the gate channel region 36. Thus, the gate electrode 50 has a width (W) extending over opposing sidewall portions 51 of the trench 38 and different lengths (L₁,L₂) over the opposing sidewall portions 51, the length L₁ over the sidewall portions 51 of the trench 20 being greater than the length L₂ over a region between the opposing sidewall portions 51. Thus, the gate channel length is increased only over the sidewall portions 51 of the trench 20 and not over the region along the entire width of the gate channel to thereby reduced the effect of any electrons entrapped in the barrier liner without any significant adverse effect on MOSFET device performance.

Other embodiments are within the spirit and scope of the appended claims.

## Claims

1. A semiconductor structure, comprising:
a semiconductor substrate;
a trench disposed in the substrate;
a dielectric material disposed in the trench;
a field effect transistor, having:
a source region;
a drain region; and
a gate channel region with a width disposed between the source and drain regions and with different lengths extending between opposing sidewall portions of the trench;
a gate electrode disposed over the gate channel region, such gate electrode having a width extending over opposing sidewall portions of the trench, such gate electrode having a length over the opposing sidewall portions greater than a length over a region between the opposing sidewall portions.

2. A semiconductor structure as claimed in claim 1, further comprising a barrier liner disposed over sidewall portions of the trench.

3. The semiconductor structure as claimed in claim 2 wherein the barrier liner is silicon nitride or silicon oxynitride.

4. The semiconductor structure as claimed in any preceding claim wherein the substrate is silicon.

5. The semiconductor structure as claimed in any preceding claim wherein the dielectric material is TEOS.

6. A method for forming a semiconductor structure, comprising:
providing a semiconductor substrate;
forming a trench in the substrate;
filling the trench with a dielectric material;
annealing the dielectric material to densify such dielectric material;
forming a field effect transistor, comprising:
forming a gate electrode between a source and drain region, such gate electrode having different lengths formed between the source and drain regions and with a width extending between opposing sidewall portions of the trench, a length over the opposing sidewall potions being formed greater than a length over a region intermediate the opposing sidewall portions.

7. A method for forming a semiconductor structure, further comprising the step of forming a barrier liner over sidewall portions of the trench, such that the dielectric material is subsequently deposited over the barrier liner.

8. The method as claimed in claim 7 wherein the barrier liner is silicon nitride or silicon oxynitride.

9. The method as claimed in claim 7 or 8 wherein the substrate is silicon.

10. The method as claimed in one of claim 7-9 wherein the dielectric material is TEOS.
